Europäisches Patentamt

European Patent Office

Office européen des brevets

(11) Publication number: 0 403 215
A2

# EUROPEAN PATENT APPLICATION

(21) Application number: 90306371.7

(51) Int. Cl.5: H03K 3/12

(22) Date of filing: 12.06.90

(30) Priority: 12.06.89 JP 150091/89

(43) Date of publication of application:
19.12.90 Bulletin 90/51

(84) Designated Contracting States:
DE FR GB

(71) Applicant: NEC CORPORATION
7-1, Shiba 5-chome Minato-ku
Tokyo 108-01(JP)

(72) Inventor: Tago, Shusei
C/o NEC Corporation, 7-1, Shiba 5-chome
Minato-ku, Tokyo(JP)

(74) Representative: Pritchard, Colin Hubert et al
Mathys & Squire 10 Fleet Street
London EC4Y 1AY(GB)

(54) Flip-flop circuit.

(57) A Flip-Flop circuit, of a current-pass switching type logical circuit, of the invention comprises a pair of data holding transistors ($Q_{11}, Q_{12}$), the emitters thereof being tied together at a first junction point (22) and being led to a constant-current source (18); and a set signal input transistor ($Q_{18}$) and a reset signal input transistor ($Q_{19}$), the emitters thereof being tied together at a second junction point (21) and being led to the constant-current source. There is provided a single level-shifting resistor (20) between the first junction point (22) and the second junction point (21) for preventing interference or concurrence between the high level of a set signal or a reset signal and the high level of the internal data held by the data holding transistors ($Q_{11}, Q_{12}$). The circuit is suitable to be fabricated in a semiconductor integrated circuit device of high packing density. The working range of power supply voltages for the circuit is wide because the level shift voltage developed across the level-shifting resistor is not influenced by the variation of the power supply voltage.

F I G .1

## FLIP-FLOP CIRCUIT

### BACKGROUND OF THE INVENTION

The present invention relates to a Flip-Flop circuit and, more particularly, to a Flip-Flop circuit of a current-pass switching type logical circuit having a set signal input or a reset signal input, which Flip-Flop circuit is well-suited to be fabricated in a semiconductor integrated circuit device of high packing density.

A conventional typical Flip-Flop circuit of a bistable multivibrator requires in a symmetrical configuration a pair of level shifting resistors in addition to two resistors for determining the necessary logical amplitude of the circuit as well as two load resistors for emitter-follower circuits. In order to highly advance the integration density of an LSI (large scale integrated) circuit, it is one of the most important matters to reduce the number of elements constituting the overall circuit as small as possible and preferably to the minimum number necessary. In this respect, the conventional Flip-Flop circuit as explained above has a disadvantage that it requires two level shifting resistors in addition to the indispensable resistors for determining the logical amplitude and the emitter-follower load resistors.

Furthermore, the conventional Flip-Flop circuit has a drawback in that a working range of power supply voltages therefor is narrow because the level shift voltage developed across each of the level shifting resistors changes dependent upon the variation of the power supply voltage.

### SUMMARY OF THE INVENTION

It is, therefore, an object of the invention to overcome the drawbacks existing in the conventional Flip-Flop circuit and to provide an improved Flip-Flop circuit which is well-suited to be fabricated in an LSI circuit.

It is another object of the invention to provide an improved Flip-Flop circuit which requires only one level shifting resistor for the whole circuit instead of two resistors as in the conventional circuit.

It is still another object of the invention to provide an improved Flip-Flop circuit wherein the level shift voltage developed across the level shifting resistor does not rely upon the power supply voltage.

The present invention provides a Flip-Flop circuit in which, in a Flip-Flop circuit comprising a first data holding transistor and a second data holding transistor, the emitters of the first data holding transistor and the second data holding transistor being connected with each other and having a common junction and being led to a constant-current source; and a set signal input transistor and a reset signal input transistor, the emitters of the set signal input transistor and the reset signal input transistor being connected with each other and being led to the constant-current source, the reading-in and holding of the data being performed by the switching of current passages, the improvement comprising:

a single level shifting resistor provided between the common junction of the emitters of the first and second data holding transistors and the constant-current source, the level shifting resistor being such that any level shift voltage developed thereacross has no reliance upon the power supply source.

### BRIEF DESCRIPTION OF THE DRAWINGS

The above and other objects, features and advantages of the present invention will be apparent from the following description of preferred embodiments of the invention explained with reference to the accompanying drawings, in which:-

Fig. 1 is a circuit diagram of an RS-type Flip-Flop circuit as a first embodiment according to the present invention;

Fig. 2 is a circuit diagram of a master-slave D-type Flip-Flop circuit as a second embodiment according to the present invention; and

Fig. 3 is a circuit diagram of a conventional RS Flip-Flop circuit.

### PREFERRED EMBODIMENTS OF THE INVENTION

Throughout the following description, similar reference numerals or symbols refer to similar elements in all Figures of the drawings.

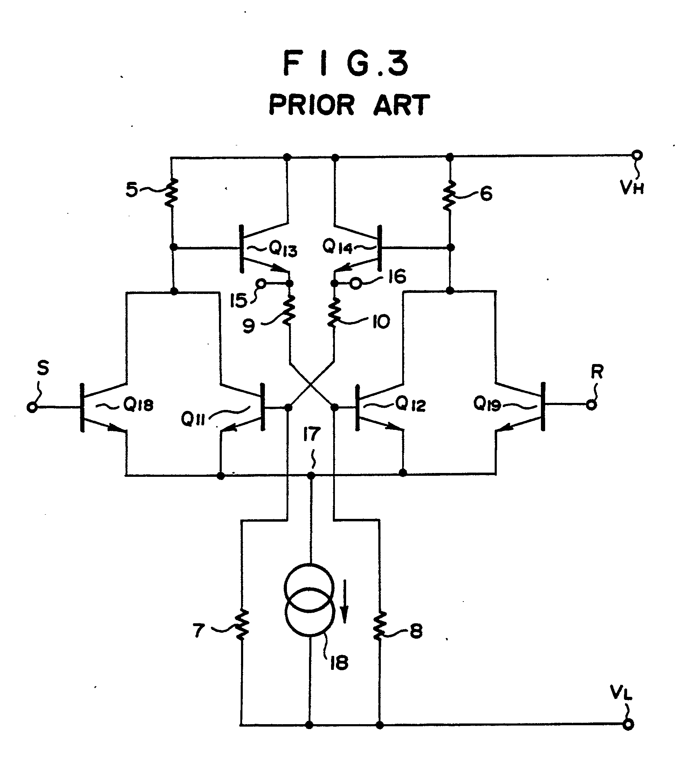

For the purpose of assisting in the understanding of the present invention, the circuit construction of a conventional Flip-Flop circuit and the problems therein will first be described by making reference to Fig. 3 before the present invention is explained.

Fig. 3 shows a circuit diagram of a typical conventional Flip-Flop circuit having a set signal input and a reset signal input. The Flip-Flop circuit shown in Fig. 3 is an RS (for reset-set) Flip-Flop circuit and has the following construction. The RS Flip-Flop circuit comprises a first data holding transistor $Q_{11}$ in which its collector is coupled to a higher potential power supply terminal $V_H$ through a resistor 5 and its emitter is connected to a lower potential power supply terminal $V_L$ through a common junction 17 and a constant-current source 18; a second data holding transistor $Q_{12}$ wherein, likewise, its collector is coupled to the higher potential power supply terminal $V_H$ through a resistor 6 and its emitter is connected to the lower potential power supply terminal $V_L$ through the common junction 17 and the constant-current source 18; a set signal input transistor $Q_{18}$ wherein its base is connected to a set signal input terminal $\underline{S}$, its collector is connected to the collector of the first data holding transistor $Q_{11}$ and its emitter is connected to the common junction 17; and a reset signal input transistor $Q_{19}$ wherein its base is connected to a reset signal input terminal $\underline{R}$, its collector is connected to the collector of the second data holding transistor $Q_{12}$ and its emitter is connected to the common junction 17. The circuit further comprises a first feed-back emitter-follower transistor $Q_{13}$ wherein its collector is directly connected to the higher potential power supply terminal $V_H$, its base is connected to the tied together collectors of the first data holding transistor $Q_{11}$ and the first input transistor $Q_{18}$ and its emitter is connected to one output terminal 15 and to the base of the second data holding transistor $Q_{12}$ through a resistor 9 and further to the lower potential power supply terminal $V_L$ through an emitter-follower load resistor 8; and a second feedback emitter-follower transistor $Q_{14}$ wherein, likewise, its collector is directly connected to the higher potential power supply terminal $V_H$, its base is connected to the tied together collectors of the second data holding transistor $Q_{12}$ and the second input transistor $Q_{19}$ and its emitter is connected to the other output terminal 16 and to the base of the first data holding transistor $Q_{11}$ through a resistor 10 and further to the lower potential power supply terminal $V_L$ through an emitter-follower load resistor 7.

.   When the level of the set signal input terminal $\underline{S}$ once becomes a high level under the state in which the reset signal input terminal $\underline{R}$ is kept at a low level, the current flows through the resistor 5 but no current flows through the resistor 6, so that the one output terminal 15 becomes a low level based on non-conducting of the emitter-follower transistor $Q_{13}$ while the other output terminal 16 becomes a high level based on conducting of the emitter-follower transistor $Q_{14}$. Even if the set signal input terminal $\underline{S}$ is changed to its low level thereafter, the current flowing in the resistor 5 is held by the first data holding transistor $Q_{11}$ until the level of the reset signal input terminal $\underline{R}$ be-

comes high, so that there occur no changes in the level of the respective output terminals 15 and 16. The circuit performance dependent upon the level conditions of the reset signal input terminal $\underline{R}$ under the state in which the set signal input terminal $\underline{S}$ is kept at its low level is the same as that in accordance with the set signal application explained above.

The resistor 9 shown in Fig. 3 is the so-called level shifting resistor which, in order to avoid concurrence or interference between the high level of the base potential of the second data holding transistor $Q_{12}$ and that of the set signal input transistor $Q_{18}$, renders the high level of the base potential of the second data holding transistor $Q_{12}$ to be lowered from the high level of the output terminal 15 by the voltage corresponding to the voltage drop developed across this level shifting resistor 9. The resistor 10 is also a level shifting resistor which renders the high level of the base potential of the first data holding transistor $Q_{11}$ to be lower than that of the output terminal 16 by the voltage drop developed across this level shifting resistor 10, thereby avoiding the concurrence or interference between the high level of the base potential of the first data holding transistor $Q_{11}$ and that of the reset signal input transistor $Q_{19}$.

The conventional Flip-Flop circuit as explained above has drawbacks in that it requires two level shifting resistors 9, 10 in addition to the indispensable resistors 5, 6 for establishing the necessary logical amplitude and the emitter-follower load resistors 7, 8, and in that a safety working range of the power supply voltages therefor is narrow because the level shift voltage developed across each of the level shifting resistors changes dependent upon the variation of the power supply voltage.

As explained in detail hereunder, according to the present invention, there is provided an improved Flip-Flop circuit in which the provision of only one level shifting resistor is sufficient and the voltage drop developed across the level shifting resistor has no reliance upon the power supply voltage.

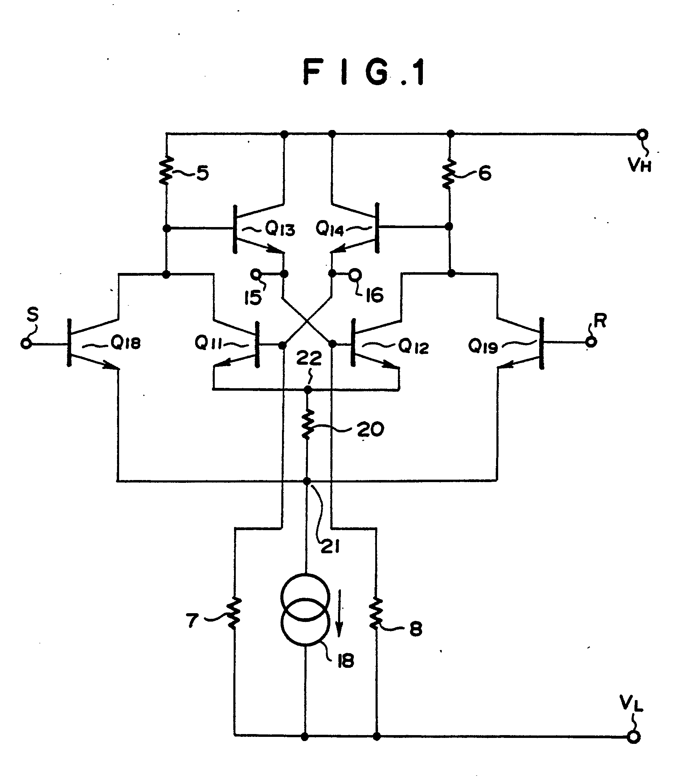

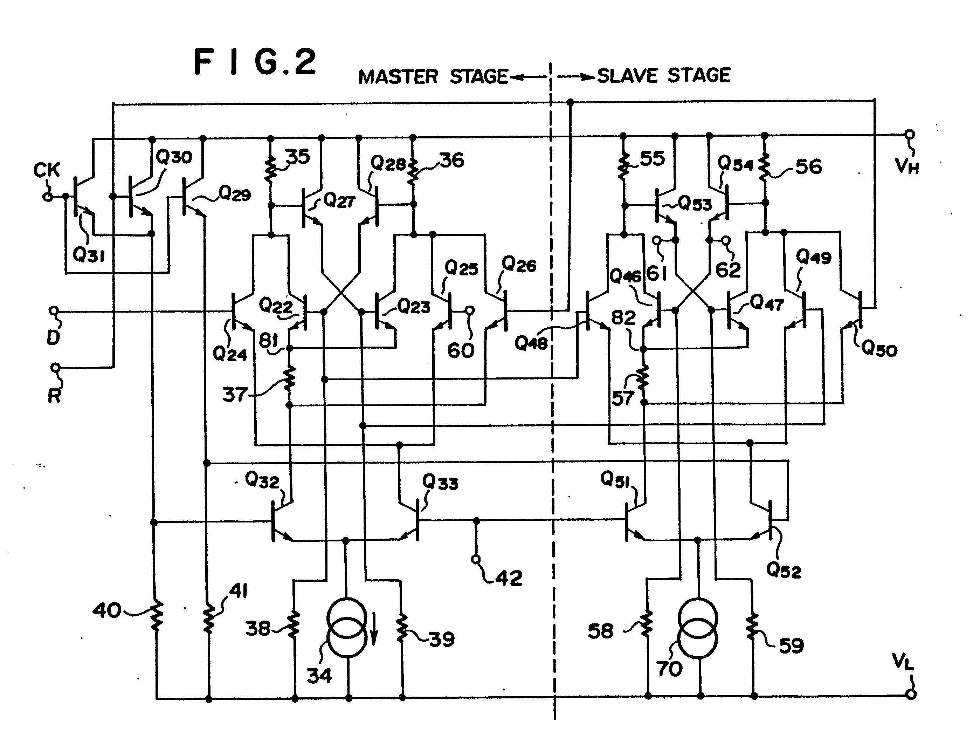

Now, the present invention is explained in detail with reference to Figs. 1 and 2.

Fig. 1 shows a circuit diagram of a Flip-Flop circuit as a first embodiment according to the present invention.

The Flip-Flop circuit of this first embodiment comprises first and second data holding transistors $Q_{11}$, $Q_{12}$ wherein the respective emitters are tied together at a junction 22 and are connected to the lower potential power supply terminal $V_L$ through a level shifting resistor represented by a reference number 20 and a constant-current source 18, and the respective collectors are connected to the higher potential power supply terminal $V_H$ through the resistors 5, 6, respectively; a set signal input transistor $Q_{18}$ wherein its base is connected to a set signal input terminal S, its collector is connected to the collector of the first data holding transistor $Q_{11}$ and its emitter is connected to the common junction 21 between the resistor 20 and the constant-current source 18; a reset signal input transistor $Q_{19}$ wherein its base is connected to a reset signal input terminal R, its collector is connected to the collector of the second data holding transistor $Q_{12}$ and its emitter is connected to the common junction 21; a first feedback emitter-follower transistor $Q_{13}$ wherein its collector is connected to the high potential power supply terminal $V_H$, its base is connected to the collector of the first data holding transistor $Q_{11}$ and its emitter is connected to one output terminal 15 and is directly connected to the base of the second data holding transistor $Q_{12}$ as well as to the lower potential power supply terminal $V_L$ through a feedback emitter-follower resistor 8; and a second feedback emitter-follower transistor $Q_{14}$ wherein, likewise, its collector is connected to the high potential power supply terminal $V_H$, its base is connected to the collector of the second data holding transistor $Q_{12}$ and its emitter is connected to the other output terminal 16 and is directly connected to the base of the first data holding transistor $Q_{11}$ as well as to the lower potential power supply terminal $V_L$ through a feedback emitter-follower resistor 7.

It can be readily understood that, from the drawings, in the Flip-Flop circuit according to the present invention there is provided only one level shifting resistor 20 instead of two resistors as in the conventional circuit as shown in Fig. 3. The resistance value of this level shifting resistor 20 is determined such that the voltage drop developed across this resistor based on the current flowing therein when either one of the data holding transistors $Q_{11}$ or $Q_{12}$ is conducting is approximately in a range from 100 mV to 200 mV.

Assuming here that both the set signal input terminal S and the reset signal input terminal R are of low levels and the one output terminal 15 is of a high level while the other output terminal 16 is of a low level as their initial state, the current is flowing in the passage defined by the resistor 6, the second data holding transistor $Q_{12}$ and the level shifting resistor 20.

When the set signal input terminal S changes to its high level from the above-mentioned state, at an initial transitory state, the base potential of the second data holding transistor $Q_{12}$ is of the same high level as of the high level of the set signal input terminal S. However, the voltage which is larger than the potential difference between the base and the emitter of the second data holding transistor $Q_{12}$ by the potential difference developed across the resistor 20 is applied between the base and the emitter of the set signal input transistor $Q_{18}$. As a consequence, since the set signal input transistor $Q_{18}$ changes from its non-conducting state to its conducting state and the second data holding transistor $Q_{12}$ changes from its conducting state to its non-conducting state, the one output terminal 15 goes to a low level and the other output terminal 16 goes to a high level. That is, the current passage is changed from one defined by the resistor 6, the second data holding transistor $Q_{12}$ and the common level shifting resistor 20 to the other one defined by the resistor 5, the first data holding transistor $Q_{11}$ and the common resistor 20.

Even when the set signal input terminal S changes to its low level again from the above state, the current which is flowing in the resistor 5 is held by the first data holding transistor $Q_{11}$ so that there occurs no change in the state of the respective output terminals 15, 16. The circuit performance dependent upon the level state of the reset signal input terminal R is the same as that with the set signal input terminal S.

Next, Fig. 2 shows a circuit diagram of a Flip-Flop circuit as a second embodiment according to the present invention. The Flip-Flop circuit shown in Fig. 2 is a typical master-slave D-type Flip-Flop circuit which has a master stage at the left-hand side from the dotted line and a slave stage at the right-hand side from the same dotted line.

The master stage of the Flip-Flop circuit comprises a plurality of NPN bipolar transistors $Q_{22}$ - $Q_{33}$, a constant-current source 34, a plurality of resistors 35 - 41, a clock signal input terminal CK, a data signal input terminal D, a reset signal input terminal R, a first reference voltage input terminal 60 and a second reference voltage input terminal 42. The emitters of the two data holding transistors $Q_{22}$, $Q_{23}$ are directly connected with each other at a junction 81 and they, together with the emitter of the reset signal input transistor $Q_{26}$, are further connected to the collector of the transistor $Q_{32}$ constituting a first differential circuit of lower second logical level through the level shifting resistor 37. As shown in the drawings, only one level shifting resistor 37 is provided in the master stage circuit.

On the other hand, the slave stage includes a plurality of NPN bipolar transistors $Q_{46}$ - $Q_{54}$, a plurality of resistors 55 - 59, a constant-current source 70, a higher potential power supply terminal $V_H$, a lower potential power supply terminal $V_L$, and a pair of output terminals 61 and 62. The emitters of the two data holding transistors $Q_{46}$, $Q_{47}$ are directly connected with each other at a junction 82 and they, together with the emitter of the reset signal input transistor $Q_{50}$, are further connected to the collector of the transistor $Q_{51}$ constituting a

second differential circuit of lower second logical level through the level shifting resistor 57. As also shown in the drawings, only one level shifting resistor 57 is provided in the slave stage circuit as in the master stage circuit.

Now, assuming that the clock signal input terminal CK is at its low level when the reset signal input terminal R is at its low level, the circuit at the master stage reads-in the data to be held next by the transistors $Q_{24}$, $Q_{25}$ and, the circuit at the slave stage holds the previous data at the output terminals 61, 62 by the data holding transistors $Q_{46}$, $Q_{47}$. Next, when the signal at the clock signal input terminal CK rises to a high level, the circuit at the master stage holds by the first and second data holding transistors $Q_{22}$, $Q_{23}$ the data read-in and, upon receiving such data from the master stage, the circuit at the slave stage outputs them to the output terminals 61, 62 by the data holding transistors $Q_{46}$, $Q_{47}$.

As is the case in the first embodiment, when the reset signal input terminal R rises from a low level to a high level, the effective resetting is ensured because, due to the level shifting resistors 37 and 57 respectively provided in the master stage circuit and the slave stage circuit as in the first embodiment, the high level of the reset signal input terminal R does not interfere or concur with the high level at the bases of the data holding transistors $Q_{22}$, $Q_{23}$ in the master stage and of the data holding transistors $Q_{46}$, $Q_{47}$ in the slave stage.

As explained above, the present invention brings about advantages over the prior art in that only one resistor is sufficient as the level shifting resistor required for preventing interference or concurrence between the high level of the set signal or reset signal and the high level of the internal data held by the respective data holding transistors, which contributes to an increase in integration or packing density of the circuit, and in that the level shift voltage developed across this level shifting resistor does not rely on variation of the power supply voltage, which allows a larger working range of power supply voltages.

Finally, although in the specific embodiments of the invention described herein, the transistors used have been specified as being NPN-type bipolar transistors, it will be understood that PNP-type bipolar transistors may also be utilized with appropriate changes being made in the polarities of the power supply sources.

While the invention has been described in its preferred embodiments, it is to be understood that the words which have been used are words of description rather than limitation and that changes within the purview of the appended claims may be made without departing from the true scope and spirit of the invention in its broader aspects.

## Claims

1. A Flip-Flop circuit comprising a first data holding transistor ($Q_{11}$) and a second data holding transistor ($Q_{12}$), the emitters of said first data holding transistor and said second data holding transistor being connected with each other and having a common junction (22) and being led to a constant-current source (18); and a set signal input transistor ($Q_{18}$) and a reset signal input transistor ($Q_{19}$), the emitters of said set signal input transistor and said reset signal input transistor being connected with each other and being led to said constant-current source (18), the reading-in and holding of the data being performed by the switching of current passages, characterized by: a single level shifting resistor (20) provided between said common junction (22) of said emitters of said first and second data holding transistors and said constant-current source, said level shifting resistor (20) being such that any level shift voltage developed thereacross has no reliance upon the power supply source.

2. An RS-type Flip-Flop circuit having a first and a second power supply terminal ($V_L$, $V_H$), a set signal input terminal (S), a reset signal input terminal (R), one and the other output terminals (15, 16), a first through a fourth resistor (5, 6, 7, 8), a constant-current source (18) and a single level shifting resistor (20), said Flip-Flop circuit is characterized by comprising: a first and a second data holding transistor ($Q_{11}$, $Q_{12}$), wherein the respective emitters are tied together and are connected to said first power supply terminal ($V_L$) through said level shifting resistor (20) and said constant-current source (18), and the respective collectors are connected to said second power supply terminal ($V_H$) through said first and second resistors (5, 6), respectively; a set signal input transistor ($Q_{18}$) wherein its base is connected to said set signal input terminal (S), its collector is connected to the collector of said first data holding transistor ($Q_{11}$) and its emitter is connected to a common junction (21) between said level shifting resistor (20) and said constant-current source (18); a reset signal input transistor ($Q_{19}$) wherein its base is connected to said reset signal input terminal (R), its collector is connected to the collector of said second data holding transistor ($Q_{12}$) and its emitter is connected to said common junction (21) between said level shifting resistor (20) and said constant-current source (18); a first feedback emitter-follower transistor ($Q_{13}$) wherein its collector is directly connected to said second power supply terminal ($V_H$), its base is connected to the collector of said first data holding transistor ($Q_{11}$) and its emitter is connected to said one output terminal (15) and is directly connected to the base of said second data holding transistor ($Q_{12}$) as well as to said first power supply terminal ($V_L$) through said fourth resistor (8); and

a second feedback emitter-follower transistor ($Q_{14}$) wherein its collector is directly connected to said second power supply terminal ($V_H$), its base is connected to the collector of said second data holding transistor ($Q_{12}$) and its emitter is connected to said the other output terminal (16) and is directly connected to the base of said first data holding transistor ($Q_{11}$) as well as to said first power supply terminal ($V_L$) through said third resistor (7).

3. A Flip-Flop circuit according to claim 2, in which said respective transistors ($Q_{11}$-$Q_{14}$,$Q_{18}$,$Q_{19}$) are all of an NPN-type bipolar transistor and, said first power supply terminal ($V_L$) is of lower potential while said second power supply terminal ($V_H$) is of higher potential.

4. A Flip-Flop circuit according to claim 2, in which said respective transistors ($Q_{11}$-$Q_{14}$,$Q_{18}$,$Q_{19}$) are all of a PNP-type bipolar transistor and, said first power supply terminal ($V_L$) is of higher potential while said second power supply terminal ($V_H$) is of lower potential.

5. A Flip-flop circuit according to claim 1, in which the resistance value of said level shifting resistor (20) is determined such that the voltage drop developed across said resistor based on the current flowing therein when either one of said first data holding transistor ($Q_{11}$) and said second data holding transistor ($Q_{12}$) is conducting is approximately in a range from 100 mV to 200 mV.

6. A master-slave D-type Flip-Flop circuit characterized by comprising:
a master stage including a first differential circuit having a pair of transistors ($Q_{32}$,$Q_{33}$); a first data holding transistor ($Q_{22}$) and a second data holding transistor ($Q_{23}$), the emitters of said first data holding transistor and said second data holding transistor being connected with each other and having a first common junction (81) and being led to a first constant-current source (34) through said differential circuit ($Q_{32}$,$Q_{33}$); a first data input transistor ($Q_{24}$) and a reference voltage input transistor ($Q_{25}$), the emitters of said first data input transistor and said reference voltage input transistor being connected with each other and being led to said first constant-current source (34) through said differential circuit ($Q_{32}$,$Q_{33}$); a first reset signal input transistor ($Q_{26}$) wherein its emitter is connected to said first differential circuit ($Q_{32}$,$Q_{33}$); and a first level shifting resistor (37) provided between said first common junction (81) of said emitters of said first and second data holding transistors ($Q_{22}$,$Q_{23}$) and

said differential circuit ($Q_{32}$,$Q_{33}$); and a slave stage including a second differential circuit having a pair of transistors ($Q_{51}$,$Q_{52}$); a third data holding transistor ($Q_{46}$) and a fourth data holding transistor ($Q_{47}$), the emitters of said third data holding transistor and said fourth data holding transistor being connected with each other and having a second common junction (82) and being led to a second constant-current source (70) through said second differential circuit ($Q_{51}$,$Q_{52}$); a second data input transistor ($Q_{48}$) and a third data input transistor ($Q_{49}$), the emitters of said second data input transistor and said third data input transistor being connected with each other and being led to said second constant-current source (70) through said second differential circuit ($Q_{51}$,$Q_{52}$); a second reset signal input transistor ($Q_{50}$) wherein its emitter is connected to said second differential circuit ($Q_{51}$,$Q_{52}$); and a second level shifting resistor (57) provided between said second common junction (82) of said emitters of said third and fourth data holding transistors ($Q_{46}$,$Q_{47}$) and said differential circuit ($Q_{51}$,$Q_{52}$).

# F I G .1

FIG.2

MASTER STAGE ← → SLAVE STAGE

F I G.3
PRIOR ART